# DEMANDE DE BREVET EUROPEEN

(11) **EP 1 162 743 A1**
(43) Date de publication de la demande: **12.12.2001**
(21) Numéro de dépôt: 01401329.6
(22) Date de dépôt: 21.05.2001
(51) Int. Cl.: H03K 5/1252, H03K 5/06

(54) **Dispositif de filtrage et de calibrage d'une impulsion d'entrée par rapport à une durée de référence**

(30) Priorité: 09.06.2000 FR 0007464
(71) Demandeur: ATMEL NANTES SA, 44300 Nantes (FR)
(72) Inventeur: Coloma, Bernard, 44100 Nantes (FR)
(74) Mandataire: Fréchède, Michel

(57) **Abrégé**

L'invention concerne un dispositif de filtrage et de calibrage d'une impulsion d'entrée par rapport à une durée de référence.
Il comprend un module de filtrage de l'impulsion d'entrée formé par un module (1) générateur d'un signal analogique de commande délivrant une première transition de tension, sur franchissement d'une valeur de seuil d'un module (2) inverseur à seuil par le signal analogique de commande par valeurs croissantes et un module de calibrage en amplitude et en durée formé par un module (3) retardateur de l'impulsion d'entrée, commandant le module (1) en commutation et un module générateur d'une deuxième transition formé par le module (2) inverseur à seuil sur franchissement par le signal analogique de commande de cette valeur de seuil par valeurs décroissantes. La durée de l'impulsion filtrée et calibrée est donnée par l'intervalle de temps séparant la première et la deuxième transition.

Application aux circuits intégrés en technologie CMOS.

## Description

L'invention concerne un dispositif de filtrage et de calibrage d'une impulsion d'entrée par rapport à une durée de référence.

Avec l'avènement du traitement et de la transmission des données numériques dans les domaines d'activité les plus variés, il est indispensable d'assurer une manipulation de ces données numériques exempte de tout défaut d'écriture et/ou de lecture en mémoire.

C'est en particulier le cas pour ce qui concerne les opérations précitées, en particulier lors de la commande d'accès en écriture/lecture des circuits mémoires contenant ces données, vis-à-vis d'un signal de commande et/ou d'un signal d'horloge de référence ou reconstitué.

A l'heure actuelle, de telles opérations sont réalisées, au niveau des circuits intégrés, constituant ces circuits mémoires, par la mise en oeuvre de deux circuits distincts visant à fournir un filtrage d'impulsions courtes, de durée inférieure à 1 ns, considérées comme impulsions parasites, suivi d'une calibration de toute impulsion, non parasite, afin d'allonger la durée de cette dernière et lui attribuer une valeur de durée spécifique.

La mise en oeuvre de deux circuits distincts physiquement présente plusieurs inconvénients.

Un premier inconvénient réside dans le fait de l'utilisation de deux étages successifs.
En effet, alors que la théorie du traitement du signal numérique a atteint un niveau de formalisation et de résolution très poussé, la matérialisation, la représentation, le traitement et la mémorisation de ces signaux reste tributaire des circuits physiques, de type analogique, nécessaires à leur mise en oeuvre. En particulier, l'utilisation de deux circuits en cascade, implantés dans des zones distinctes d'un même circuit intégré, introduit un retard effectif, de quelques nanosecondes, dans la propagation du signal de commande d'accès à ces données numériques, ce qui, pour un nombre d'accès très important, provoque une augmentation importante du temps de traitement.

Un deuxième inconvénient réside dans l'implantation séparée des deux circuits précités, laquelle provoque, nécessairement, un surcoût en nombre de transistors et en surface de silicium utilisé, du fait, notamment, de la duplication inévitable des zones d'implantation des circuits de polarisation et/ou d'entrée/sortie.

La présente invention a pour objet de remédier aux inconvénients précités, par la mise en oeuvre d'un circuit unique assurant la double fonction de filtrage et de calibration d'impulsions, notamment d'impulsions de commande d'accès à des circuits mémoires réalisés sous forme de circuits intégrés.

En particulier, la présente invention a pour objet, dans le cadre d'une mise en oeuvre en technologie CMOS, de réduire, au minimum dans un rapport deux, le nombre de transistors nécessaires à la mise en oeuvre des fonctions de filtrage et de calibrage correspondantes.

En conséquence, un autre objet de la présente invention est, dans le cade d'une mise en oeuvre en technologie CMOS, une réduction correspondante de la surface de silicium nécessaire à l'intégration de ces fonctions.

Un autre objet de la présente invention est, enfin, dans le cadre d'une mise en oeuvre en technologie CMOS, une réduction correspondante des temps de propagation des signaux mis en oeuvre, et, en conséquence, une augmentation correspondante de la vitesse, mesurée en temps d'accès, des fonctions de lecture/écriture, vis-à-vis des circuits connus de l'art antérieur.

Le dispositif de filtrage et de calibrage d'une impulsion d'entrée par rapport à une durée de référence, objet de l'invention, est remarquable en ce qu'il comprend au moins, alimentés entre une tension d'alimentation et une tension de référence, un module de filtrage en durée de l'impulsion d'entrée comprenant un module générateur d'un signal analogique de commande, d'amplitude sensiblement monotone croissante à partir de la tension de référence en fonction de la durée de l'impulsion d'entrée, et un module inverseur à seuil de déclenchement, dont la valeur de seuil de déclenchement est représentative, vis-à-vis du signal analogique de commande, de cette durée de référence, ce module inverseur à seuil de déclenchement recevant ce signal analogique de commande et délivrant une première transition de tension du niveau de la tension d'alimentation au niveau de la tension de référence, sur franchissement par ce signal analogique de commande de la valeur de seuil par valeurs croissantes, mais ne délivrant aucune transition de tension sinon.

Le dispositif comporte en outre un module de calibrage en amplitude et en durée de l'impulsion d'entrée comprenant un module retardateur d'une valeur de retard calibrée déterminée, recevant cette impulsion d'entrée et délivrant une impulsion d'entrée retardée, cette impulsion d'entrée retardée commandant le module générateur d'un signal analogique de commande pour délivrer ce signal analogique de commande sensiblement monotone décroissant à partir d'une valeur déterminée, supérieure à la valeur de seuil, et un module générateur d'une deuxième transition de tension, du niveau de la tension de référence au niveau de la tension d'alimentation, constitués par le module inverseur à seuil de déclenchement recevant la deuxième transition de tension sur franchissement par le signal analogique de commande de cette valeur de seuil par valeurs décroissantes. Ceci permet, d'une part, de filtrer toute impulsion d'entrée dont la durée est inférieure à la durée de référence, et, d'autre part, de substituer à toute impulsion d'entrée dont la durée est supérieure à la durée de référence une impulsion calibrée dont l'amplitude est égale à celle de la première et de la deuxième transition et dont la durée, au moins égale ou supérieure à la valeur de retard calibrée, est égale à l'intervalle de temps séparant la première et la deuxième transition de tension.

Le dispositif objet de la présente invention trouve application à la mise en oeuvre d'étapes de commande d'accès en lecture/écriture de circuits mémoires en technologie CMOS.

Il sera mieux compris à la lecture de la description et à l'observation des dessins ci-après dans lesquels :
- la figure 1 représente, à titre illustratif, un mode de réalisation préférentiel du dispositif objet de la présente invention ;
- les figures 2a et 2b représentent différents chronogrammes de signaux relevés aux points de test de la figure 1 dans le cas de la calibration d'une impulsion longue, respectivement d'une impulsion courte ;
- la figure 3 représente, à titre illustratif, un chronogramme comparatif d'impulsions d'entrée, respectivement de sortie, obtenues grâce à la mise en oeuvre du dispositif objet de l'invention, tel que représenté en figure 1.

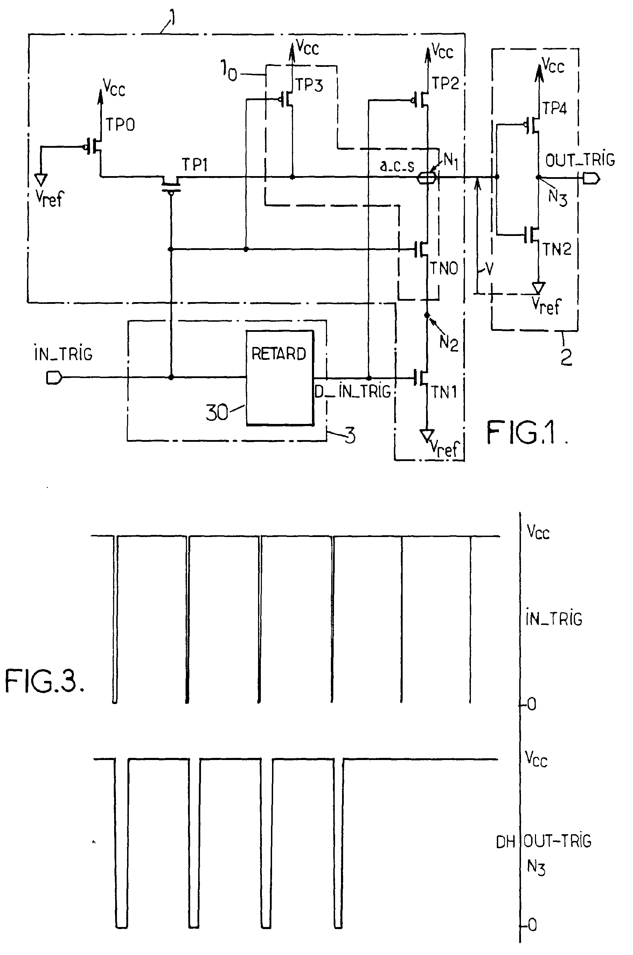

Une description plus détaillée du dispositif de filtrage et de calibrage d'une impulsion d'entrée par rapport à une durée de référence conforme à l'objet de la présente invention sera maintenant donnée en liaison avec la figure 1 et les figures suivantes.

Sur la figure précitée, on a représenté un mode de réalisation particulier non limitatif d'un dispositif de filtrage et de calibrage d'une impulsion d'entrée par rapport à une durée de référence conforme à l'objet de la présente invention.

Ce mode de réalisation est un mode de réalisation en technologie CMOS dans le but de réaliser une mise en oeuvre sous forme de circuit intégré et de permettre, notamment, en raison des finesses de gravure actuellement atteintes et des temps de commutation correspondants, des valeurs de durée d'impulsion très faibles pouvant être comprises entre 1 ns et sensiblement la durée de l'impulsion d'entrée.

En conséquence, le dispositif objet de la présente invention comprend différents composants alimentés entre une tension d'alimentation, notée Vcc, et une tension de référence, notée Vref.

La tension d'alimentation peut par exemple correspondre à une tension d'alimentation classique en technologie CMOS, c'est-à-dire une tension d'alimentation de 5 volts ou inférieure, alors que la tension de référence n'est autre que la tension de masse à 0 volt.

Ainsi que représenté sur la figure 1, le dispositif objet de la présente invention comprend un module de filtrage en durée de l'impulsion d'entrée, l'impulsion d'entrée étant notée in_trig. Ce module de filtrage en durée comprend un module 1 générateur d'un signal analogique de commande, noté a_c_s, signal dont l'amplitude est sensiblement monotone croissante à partir de la tension de référence Vref en fonction de la durée de l'impulsion d'entrée in_trig.

En outre, le module de filtrage en durée de l'impulsion d'entrée comprend un module 2 inverseur à seuil de déclenchement dont la valeur de seuil de déclenchement, notée Vthres, est représentative vis-à-vis du signal analogique de commande de la durée de référence précitée. Le module 2 inverseur à seuil de déclenchement reçoit le signal analogique de commande a_c_s et délivre une première tension de transition, notée T₁, du niveau de la tension d'alimentation Vcc au niveau de la tension de référence Vref. Cette première transition T₁ est délivrée sur franchissement par le signal analogique de commande a_c_s de la valeur de seuil Vthres par valeurs croissantes.

Au contraire, le module 2 inverseur à seuil de déclenchement ne délivre aucune transition de tension dans le cas où aucun franchissement par le signal analogique de commande a_c_s de la valeur de seuil n'est réalisé.

Ainsi qu'on l'observera en outre sur la figure 1, le dispositif objet de la présente invention comprend un module 3 de calibrage en amplitude et en durée de l'impulsion d'entrée in_trig comportant un module 30 retardateur d'une valeur de retard calibré déterminée, ce module 30 recevant l'impulsion d'entrée in_trig et délivrant une impulsion d'entrée retardée, notée d_in_trig. Cette impulsion d'entrée retardée commande le module 1 générateur d'un signal analogique de commande pour délivrer le signal analogique de commande a_c_s dont l'amplitude est alors sensiblement monotone décroissante à partir d'une valeur déterminée supérieure à la valeur de seuil Vthres, introduite du fait de l'existence du module 2 inverseur à seuil de déclenchement.

Enfin, le dispositif objet de l'invention comporte un module générateur d'une deuxième transition de tension, notée T₂, cette transition intervenant du niveau de la tension de référence Vref au niveau de la tension d'alimentation Vcc, ce module générateur de la deuxième transition T₂ étant constitué par le module 2 inverseur à seuil de déclenchement recevant le signal analogique de commande a_c_s et délivrant la deuxième transition de tension T₂ sur franchissement par le signal analogique de commande précité de la valeur de seuil Vthres par valeurs décroissantes.

Le mode opératoire précité permet, d'une part, de filtrer toute impulsion d'entrée in_trig dont la durée est inférieure à la durée de référence et, d'autre part, de substituer à toute impulsion d'entrée in_trig dont la durée est supérieure à la durée de référence une impulsion calibrée dont l'amplitude est égale à celle de la première et de la deuxième transition T₁, T₂ et dont la durée est au moins égale ou supérieure à la valeur de retard calibrée. En fait, la durée de l'impulsion calibrée déterminée par l'intervalle de temps séparant la première T₁ de la deuxième T₂ transition, est égale à l'intervalle de temps séparant les transitions précitées.

Un mode de mise en oeuvre spécifique du dispositif objet de la présente invention en technologie CMOS sera maintenant décrit en liaison avec la figure 1. Dans le mode de réalisation précité, le module 1 générateur d'un signal analogique de commande comporte au moins, pour former le module de filtrage en durée, et alimentée entre la tension d'alimentation Vcc et la tension de référence Vref, une branche inverseuse 1₀ formée par un premier transistor PMOS, TP₃, ce transistor étant connecté en série drain-source avec un premier transistor NMOS, TN₀. L'électrode de grille du premier transistor PMOS TP₃ et NMOS TN₀ reçoit en parallèle l'impulsion d'entrée in_trig. En outre, le module 1 générateur d'un signal analogique de commande comporte un deuxième transistor NMOS, noté TN₁, dont l'électrode de source est connectée en série au noeud N₂ avec la branche inverseuse 1₀ par l'électrode de drain du premier transistor NMOS TN₀. En outre, l'électrode de grille du deuxième transistor NMOS TN₁ reçoit l'impulsion retardée d_in_trig. Le point commun drain-source au noeud N₁ entre le premier transistor PMOS TP₃ et le premier transistor NMOS TN₀ est connecté à l'entrée du module 2 inverseur à seuil de déclenchement et délivre le signal analogique de commande a_c_s.

En outre, et dans le même mode de réalisation tel que représenté en figure 1, le module 1 générateur du signal analogique de commande a_c_s comporte, pour former le module de calibrage en amplitude et en durée et délivrer le signal analogique de commande d'amplitude sensiblement monotone décroissante, un deuxième transistor PMOS, TP₂, dont l'électrode de source est connectée à la tension d'alimentation Vcc et dont l'électrode de drain est connectée au point commun drain-source N₁ entre le premier transistor PMOS TP₃ et le premier transistor NMOS TN₀ formant la branche inverseuse 1₀. L'électrode de grille du deuxième transistor PMOS TP₂ reçoit l'impulsion d'entrée retardée d_in_trig.

Enfin, le module 2 inverseur à seuil de déclenchement comporte un transistor PMOS TP₄ et un transistor NMOS TN₂ connectés en série drain-source entre la tension d'alimentation Vcc et la tension de référence Vref. L'électrode de grille du transistor PMOS TP₄ et du transistor NMOS TN₂ est connectée en parallèle et reçoit le signal analogique de commande a_c_s et délivre au point commun drain-source des transistors TP₄ et TN₂, point noté N₃, le signal de sortie noté out_trig.

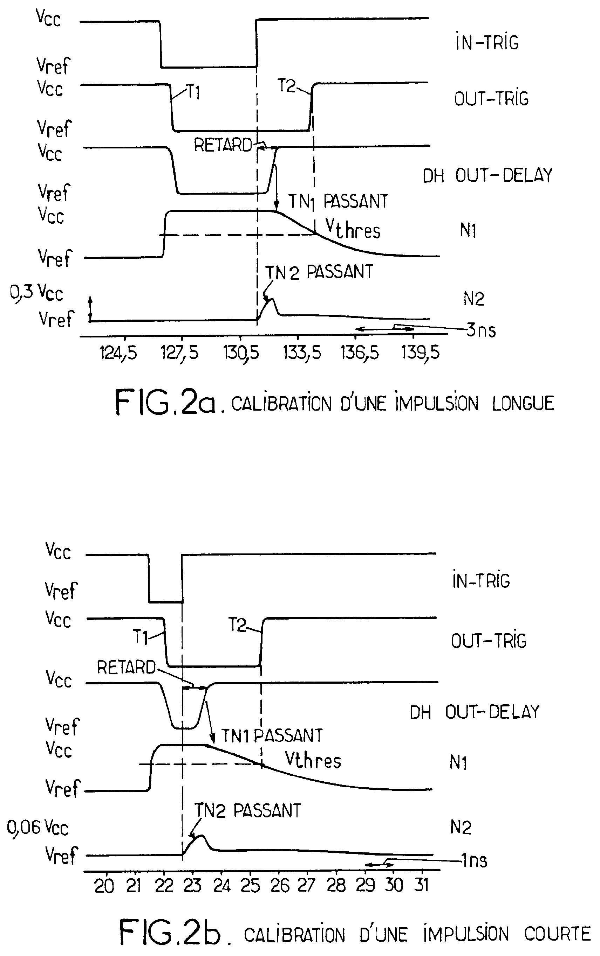

Le mode opératoire du dispositif représenté en figure 1 conforme à l'objet de la présente invention est maintenant explicité en liaison avec les figures 2a dans le cas de la calibration d'une impulsion longue et 2b dans le cas de la calibration d'une impulsion courte.

Ainsi, le même circuit engendre simultanément les fonctions de filtrage et de calibration de chaque impulsion d'entrée in_trig.

La valeur minimale de l'impulsion en sortie out_trig est déterminée par la valeur du retard engendré par le module de retard 30.

L'état au repos du signal d'entrée, c'est-à-dire des impulsions in_trig est au niveau analogique haut, c'est-à-dire à la tension d'alimentation Vcc.

Le niveau de filtrage est déterminé par la résistance équivalente des transistors TN₀, premier transistor NMOS, et TP₃, premier transistor PMOS, constitutifs de la branche inverseuse 1₀.

Le réglage de la valeur du retard introduit par le module de retard 30 agit directement sur la valeur de la durée minimale de l'impulsion en sortie out_trig.

Lorsque l'impulsion d'entrée in_trig passe à la valeur analogique 0, le premier transistor NMOS TN₀ passe progressivement à l'état bloqué, alors que les transistors TP₂ et TN₁ étaient préalablement à l'état conducteur.

Le transistor NMOS TN₁ constituant le deuxième transistor NMOS en série avec la branche inverseuse 1₀ reste à l'état conducteur tant que l'impulsion retardée d_in_trig n'est pas appliquée sur l'électrode de grille de ce dernier.

Le premier transistor PMOS TP₃ commuté par l'impulsion d'entrée devient passant et tente alors d'imposer le niveau de tension haut, entrant ainsi en conflit avec le premier transistor NMOS TN₀.

Deux cas sont alors à envisager : cas d'une impulsion longue dans le cas de la figure 2a, respectivement d'une impulsion courte dans le cas de la figure 2b.

### Cas d'une impulsion longue, une impulsion longue étant supérieure à la durée de référence.:

- le premier transistor PMOS TP₃ impose le niveau haut ;
- le deuxième transistor NMOS TN₁ passe alors à l'état bloqué ;
- le transistor TP₁ commandé par l'impulsion d'entrée devient alors passant et permet au transistor de charge PMOS TP₀ connecté en cascade avec le transistor TP₁, l'électrode de grille du transistor de charge TP₀ étant connectée à la tension de référence Vref, de charger le noeud N₁. Les transistors de charge TP₀ et de commutation de charge TP₁ peuvent être choisis de façon à présenter une largeur de canal importante, afin de leur permettre de délivrer un courant important et de charger le noeud N₁ de manière très rapide ;
- à la fin du retard introduit par le module de retard 30 sur l'impulsion d'entrée, l'impulsion retardée d_in_trig commande la conduction du deuxième transistor PMOS TP₂, lequel entre en conduction et amène sur le noeud N₁ le niveau de tension d'alimentation Vcc à la fin du retard engendré par le module de retard 30.

### Cas d'une impulsion courte.

Dans le cas d'une impulsion courte, ainsi que représenté en figure 2b :
- le premier transistor PMOS TP₃ passe à l'état bloqué sur apparition de l'impulsion d'entrée in_trig ;
- le premier transistor NMOS TN₀ maintient le niveau bloqué ;
- le deuxième transistor NMOS TN₁ connecté en série avec la branche inverseuse 1₀ reste passant en raison du retard apporté par le module de retard 30 sur l'impulsion d'entrée, l'impulsion d'entrée retardée d_in_trig étant suffisamment retardée pour maintenir le transistor TN₁ passant.

Dans les deux cas d'une impulsion longue, ainsi que représenté 2a, ou courte, ainsi que représenté en figure 2b, le module 2 d'inversion constitué par les transistors PMOS TP₄ et NMOS TN₂, permet de redonner au signal de sortie out_trig la polarité du signal d'entrée et de délivrer ainsi une impulsion calibrée dont la durée correspond à la durée comprise entre les transitions de tension T₁ et T₂. Cette durée correspond à la somme du retard introduit par le module retardateur 30, du temps de décharge du transistor NMOS TN₁ à la valeur de seuil et du temps de commutation du module d'inversion 2.

En ce qui concerne la création de la première transition T₁, on indique que celle-ci intervient dès le passage à la tension de référence de l'impulsion d'entrée in_trig au temps de commutation du premier transistor NMOS TN₀ près, alors que la deuxième transition T₂ intervient sur franchissement de la tension délivrée au noeud N₁ par valeurs monotones décroissantes de la tension analogique de commande a_c_s délivrée au noeud N₁.

Sur la figure 2a, l'échelle temporelle est de 3 ns entre deux graduations pour une impulsion dite longue, et sur la figure 2b, l'échelle temporelle est de 1 ns entre deux graduations pour une impulsion dite courte.

Enfin, sur la figure 3, on a représenté différentes impulsions d'entrée de durée successivement décroissante et les impulsions de sortie correspondantes out_trig, lesquelles ne sont engendrées grâce au dispositif objet de la présente invention que pour des impulsions d'entrée in_trig de durée supérieure à une valeur minimum, les deux dernières impulsions représentées en figure 3 étant engendrées par des impulsions parasites de très faible durée et n'étant pas génératrices d'une impulsion calibrée, ces impulsions parasites étant ainsi filtrées.

## Revendications

1. Dispositif de filtrage et de calibrage d'une impulsion d'entrée par rapport à une durée de référence, **caractérisé en ce qu'**il comprend au moins, alimentés entre une tension d'alimentation et une tension de référence :
■ un module de filtrage en durée de ladite impulsion d'entrée comportant :
- des moyens générateurs d'un signal analogique de commande, d'amplitude sensiblement monotone croissante à partir de la tension de référence en fonction de la durée de l'impulsion d'entrée ;
- des moyens inverseurs à seuil de déclenchement, dont la valeur de seuil de déclenchement est représentative, vis-à-vis du signal analogique de commande, de ladite durée de référence, lesdits moyens inverseurs à seuil de déclenchement recevant ledit signal analogique de commande et délivrant une première transition de tension du niveau de la tension d'alimentation au niveau de ladite tension de référence, sur franchissement par ledit signal analogique de commande de ladite valeur de seuil par valeurs croissantes, lesdits moyens inverseurs à seuil de déclenchement ne délivrant aucune transition de tension sinon ;
ledit dispositif comportant en outre :
■ un module de calibrage en amplitude et en durée de ladite impulsion d'entrée, comportant :
- des moyens retardateurs d'une valeur de retard calibrée déterminée, recevant ladite impulsion d'entrée et délivrant une impulsion d'entrée retardée, ladite impulsion d'entrée retardée commandant lesdits moyens générateurs d'un signal analogique de commande pour délivrer ledit signal analogique de commande d'amplitude sensiblement monotone décroissante à partir d'une valeur déterminée, supérieure à ladite valeur de seuil ;
- des moyens générateurs d'une deuxième transition de tension, du niveau de la tension de référence au niveau de la tension d'alimentation, constitués par lesdits moyens inverseurs à seuil de déclenchement recevant ledit signal analogique de commande et délivrant ladite deuxième transition de tension sur franchissement par ledit signal analogique de commande de ladite valeur de seuil par valeurs décroissantes, ce qui permet, d'une part, de filtrer toute impulsion d'entrée dont la durée est inférieure à la durée de référence, et, d'autre part, de substituer à toute impulsion d'entrée dont la durée est supérieure à la durée de référence une impulsion calibrée, dont l'amplitude est égale à celle de la première et de la deuxième transition et dont la durée, au moins égale ou supérieure à la valeur de retard calibrée, est égale à l'intervalle de temps séparant la première et la deuxième transition de tension.

2. Dispositif selon la revendication 1, **caractérisé en ce que**, pour une réalisation en technologie CMOS, lesdits moyens générateurs d'un signal analogique de commande comportent au moins, pour former ledit module de filtrage en durée, alimentés entre la tension d'alimentation et la tension de référence :
- une branche inverseuse formée par un premier transistor PMOS (TP₃), connecté en série drain-source avec un premier transistor NMOS (TN₀), l'électrode de grille du premier transistor PMOS (TP₃) et NMOS (TN₀) recevant en parallèle ladite impulsion d'entrée ;
- un deuxième transistor NMOS (TN₁) dont l'électrode de source est connectée en série avec ladite branche inverseuse, par l'électrode de drain du premier transistor NMOS (TN₀), et dont l'électrode de grille reçoit ladite impulsion retardée, le point commun drain-source (N₁) entre ledit premier transistor PMOS (TP₃) et ledit premier transistor NMOS (TN₀) étant connecté à l'entrée desdits moyens inverseurs à seuil de déclenchement et délivrant ledit signal analogique de commande.

3. Dispositif selon les revendications 1 et 2, **caractérisé en ce que**, pour une réalisation en technologie CMOS, lesdits moyens générateurs d'un signal analogique de commande comportent en outre, pour former ledit module de calibrage en amplitude et en durée et délivrer ledit signal analogique de commande d'amplitude sensiblement monotone décroissante, un deuxième transistor PMOS (TP₂) dont l'électrode de source est connectée à ladite tension d'alimentation et dont l'électrode de drain est connectée audit point commun drain-source (N₁) entre ledit premier transistor PMOS (TP₃) et ledit premier transistor NMOS (TN₀), l'électrode de grille dudit deuxième transistor PMOS (TP₂) recevant ladite impulsion d'entrée retardée.

4. Dispositif selon l'une des revendications 1 à 3, **caractérisé en ce que** lesdits moyens inverseurs à seuil de déclenchement comportent un transistor PMOS (TP₄) et un transistor NMOS (TN₂) connectés en série drain-source entre la tension d'alimentation et la tension de référence, l'électrode de grille du transistor PMOS (TP₄) et du transistor NMOS (TN₂) étant connectée en parallèle et recevant ledit signal analogique de commande.
